# EUROPÄISCHE PATENTSCHRIFT

(11) **EP 2 562 137 B1**
(45) Veröffentlichungstag und Bekanntmachung des Hinweises auf die Patenterteilung: **25.05.2016**
(21) Anmeldenummer: 12176804.8
(22) Anmeldetag: 18.07.2012
(51) Int. Cl.: C01B 33/037

(54) **Verfahren zur Reinigung von polykristallinen Siliciumbruchstücken**
Process for cleaning polycrystalline silicon chunks
Procédé de nettoyage de morceaux de silicium polycristallin

(30) Priorität: 29.07.2011 DE 102011080105
(43) Veröffentlichungstag der Anmeldung: 27.02.2013
(73) Patentinhaber: Wacker Chemie AG, 81737 München (DE)
(72) Erfinder: Gailer, Thomas, 84489 Burghausen (DE); Kellner, Rudolf, 84508 Burgkirchen (DE); Wochner, Dr. Hanns, 84489 Burghausen (DE)
(74) Vertreter: Potten, Holger

(56) Entgegenhaltungen:
- EP-A1- 1 876 143
- EP-A2- 1 894 887
- EP-A2- 2 192 086
- DE-A1- 4 325 543
- DE-A1- 10 063 600
- DE-A1- 19 815 039
- DE-A1-102007 039 626
- DE-A1-102009 023 124
- US-A- 5 175 502
- US-A- 5 439 569

## Beschreibung

Die Erfindung betrifft ein Verfahren zur Reinigung von polykristallinen Siliciumbruchstücken.

Polykristallines Silicium, kurz Polysilicium, wird heute in großen Mengen industriell hergestellt und dient unter anderem als Rohstoff für Anwendungen in der Photovoltaik und für die Herstellungen von Einkristallen bei Waferherstellern. Bei allen Anwendungen wird eine hohe Reinheit des Rohstoffes gewünscht.

Hochreines Silicium erhält man üblicherweise durch thermische Zersetzung leicht flüchtiger und deshalb einfach über Destillationsverfahren zu reinigender Siliciumverbindungen, wie z.B. Trichlorsilan. Das Silicium wird dabei polykristallin in Form von Stäben mit typischen Durchmessern von 70 bis 300 mm und Längen von 500 bis 2500 mm abgeschieden.

Ein wesentlicher Teil dieser polykristallinen Stäbe wird anschließend mittels Tiegelziehen (Czochralski- oder CZ-Verfahren) zu Einkristallen weiterverarbeitet oder zur Herstellung von polykristallinem Grundmaterial für die Photovoltaik verwendet. In beiden Fällen wird hochreines, schmelzflüssiges Silicium benötigt. Dazu wird festes Silicium in Tiegeln aufgeschmolzen.

Dabei werden die polykristallinen Stäbe vor dem Aufschmelzen zerkleinert, üblicherweise mittels metallischen Brechwerkzeugen, wie Backen- oder Walzenbrechern, Hämmern oder Meißeln.

Beim Zerkleinern wird das hochreine Silicium aber mit Fremdatomen kontaminiert. Dabei handelt es sich insbesondere um Metallcarbid- oder Diamantrückstände sowie um metallische Verunreinigungen.

Daher wird Siliciumbruch für höherwertige Anwendungen wie z.B. für das Einkristallziehen vor der Weiterverarbeitung und/oder der Verpackung gereinigt. Dies geschieht üblicherweise in einem oder mehreren chemischen Nassreinigungsschritten.

Dabei kommen Mischungen aus verschiedenen Chemikalien und/oder Säuren zum Einsatz, um insbesondere anhaftende Fremdatome wieder von der Oberfläche zu entfernen.

EP 0 905 796 B1 beansprucht ein Verfahren zur Herstellung von Silicium, das eine niedrige Metallkonzentration aufweist, dadurch gekennzeichnet, dass das Silicium in einer Vorreinigung in zumindest einer Stufe mit einer oxidierenden Reinigungslösung gewaschen wird, die die Verbindungen Flurwasserstoffsäure (HF), Chlorwasserstoffsäure (HCl) und Wasserstoffperoxid (H₂O₂) enthält und in einer Hauptreinigung in einer weiteren Stufe mit einer Reinigungslösung gewaschen wird, die Salpetersäure (HNO₃) und Fluorwasserstoffsäure (HF) enthält, und zur Hydrophilierung in einer weiteren Stufe mit einer oxidierenden Reinigungslösung gewaschen wird.

Bedingt durch die Verschleppung von Säure in das Spülwasser, durch die chemische Reaktion mit Metallpartikeln und für das Auflösen des Siliziums bei HF/HNO3-Ätzen wird Säure verbraucht.

Zur Aufrechterhaltung einer bestimmten Säurekonzentration ist es daher ständig notwendig, frische Säure nachzudosieren.

DE 10 2007 039 626 A1 offenbart ein Verfahren zur Reinigung von polykristallinen Siliziumbruchstücken in einem sauren Reinigungsbad, wobei die Reinigung mehrere Reinigungszyklen umfasst, wobei bei jedem Reinigungszyklus eine bestimmte Menge an Säure verbraucht wird, wobei mittels einem Dosiersystem unverbrauchte Säure dem Reinigungsbad zugeführt wird. Das Dokument offenbart weiterhin ein Verfahren zur Reinigung von polykristallinen Siliziumbruchstücken in einem sauren Reinigungsbad, das einen Säurekreislauf umfasst, in dem Säure umgewälzt wird.

Anders als bei der Reinigung von Siliciumscheiben weist das zu reinigende Schüttgut bedingt durch die unterschiedlichen Größenklassen der polykristallinen Siliciumbruchstücke ständig wechselnde Oberflächen auf.

Polysilicium lässt sich in Bruchgrößen klassifizieren, die im Folgenden jeweils als längste Entfernung zweier Punkte auf der Oberfläche eines Siliciumbruchstücks (=max. Länge) wie folgt definiert ist:
- Bruchgröße 1 (BG 1) in mm: ca. 3 bis 15;
- Bruchgröße 2 (BG 2) in mm: ca. 10 bis 40;
- Bruchgröße 3 (BG 3) in mm: ca. 20 bis 60;
- Bruchgröße 4 (BG 4) in mm: ca. 40 bis 110;
- Bruchgröße 5 (BG 5) in mm: ca. 110 bis 170;
- Bruchgröße 6 (BG 6) in mm: ca. 150 bis 230.

Die spezifischen Oberflächen für die verschiedenen Bruchgrößen betragen:
- BG 6: ca. 0,05 cm²/g;
- BG 5: ca. 0,5 cm²/g_{;}
- BG 4: ca. 1 cm²/g;
- BG 3: ca. 2 cm²/g;
- BG 2 : ca. 5 cm²/g;
- BG 1: ca. 10 cm²/g.

Die Zudosiermenge an frischen Säuren in HF/HNO₃-Mischungen bzw. HF/HCl/H₂O₂-Lösungen, vgl. EP 0 905 796 B1, schwankt zwischen BG 6 und Bruchgröße 1 zwischen 1 und 2000 Liter pro Stunde.

Auch bei gleichen Bruchgrößen des Polysiliciums schwankt die spezifische Oberfläche zwischen verschiedenen Chargen um mindestens 20%. Auch hier schwanken der Säureverbrauch und damit die benötigten Zudosiermengen von Charge zu Charge.

Dies bedeutet, dass die Nachdosierung auch bei polykristallinen Siliciumbruchstücken ein- und derselben Bruchgröße ständig angepasst werden müsste, um die Bedingungen des Reinigungsbads konstant zu halten.

Um eine stabile Prozessführung bei der Reinigung von Polysilicium, das für Anwendungen in der Halbleiterindustrie vorgesehen ist, sicherzustellen, müsste der Erfahrung nach das Dosiersystem eine Genauigkeit von 10% oder besser aufweisen.

Ein manuelles Nachdosieren (Handfahrweise) ist sehr aufwändig und kann eine solche Dosiergenauigkeit kaum sicherstellen.

Deshalb wird die Nachdosierung für eine bestimmte Bruchgrößenklasse immer an Chargen mit der größten spezifischen Oberfläche innerhalb dieser Bruchgrößenklasse angepasst.

Ein Grossteil der Charge einer bestimmten Bruchgröße fährt damit immer mit einer Überdosierung, was zwangsläufig zu einem höheren Säureverbrauch führt und den Prozess unwirtschaftlicher macht.

Alternativ kann eine weitgehend automatisierte Regelung der Nachdosierung erfolgen.

Regelkreise werden in chemischen Anlagen unter anderem zur Temperaturregelung, zur Füllstandsregelung, zur Durchflussregelung oder zur pH-Wert Regelung verwendet.

Übliche Regelungen basieren auf kontinuierlichen Messungen der zu regelnden Größe.

Hierfür werden entsprechende Sensoren eingesetzt, die kontinuierlich Messwerte liefern.

Allerdings sind Sensoren, mit denen die Zusammensetzung von mehrere Komponenten enthaltenden chemischen Reinigungslösungen kontinuierlich bestimmt werden und die die entsprechenden Messwerte ohne Zeitverzögerung liefern könnten, im derzeitigen Stand der Technik nicht verfügbar.

Die Bestimmung der Zusammensetzung von solchen Lösungen erfordert eine parallele Durchführung von mehreren, verschiedenen Analysenverfahren zur Bestimmung der Einzelkomponenten.

Beispielsweise sind ionenselektive Elektroden zur potentiometrischen Bestimmung von Fluorid bekannt, mit der der HF-Gehalt einer HF/HNO3-Ätzmischung bestimmt werden kann.

Der Nitratgehalt in einer HF/HNO3-Mischung lässt sich beispielsweise mittels eines photometrischen Verfahrens bestimmen.

Alternativ lässt sich die Zusammensetzung solcher Lösungen bestimmen, indem ein Titrationsverfahren auf der Basis der DET-Methode (DET= Dynamic Equivalence Point-Titration) angewendet wird.

Ein entsprechendes Verfahren ist z.B. aus DE 198 52 242 A1 bekannt.

Es betrifft die Konzentrationsbestimmung von Säuren in einem Säuregemisch mittels dynamischer Äquivalenzpunkttitration, wobei das Säuregemisch bestehend aus Salpetersäure, Flusssäure, Hexafluorokieselsäure und gegebenenfalls weiteren organischen und/oder anorganischen Verbindungen mit einem basischen Titer versetzt wird, bis ein Äquivalenzpunkt erreicht wird, welcher zwischen einer Wasserstoffionenkonzentration von 10⁻² bis 10^{-3,5} liegt, anschließend solange mit dem Titer versetzt wird, bis ein Äquivalenzpunkt erreicht wird, welcher zwischen einer Wasserstoffionenkonzentration von 10⁻⁴ bis 10⁻⁵ liegt und schließlich solange mit dem Titer versetzt wird, bis ein Äquivalenzpunkt erreicht wird, welcher zwischen einer Wasserstoffionenkonzentration von 10⁻¹⁰ bis 10⁻¹¹ liegt.

Allerdings liefern sowohl das eben beschriebene Titrationsverfahren als auch die parallel durchgeführten Analysenverfahren nur alle 5 bis 60 Minuten einen Wert.

Zur Nachdosierung von Säuren können Membranpumpen oder gravimetrische Systeme wie Dosierwaagen zum Einsatz kommen.

Es hat sich aber gezeigt, dass mit solchen Dosierpumpen nicht immer die gewünschte Dosiergenauigkeit von 10% oder besser erreichbar ist.

Üblicherweise weisen Druckluftmembranpumpen und Motordosierpumpen ein Entlüftungsventil in der Ansaugleitung auf. Dies soll dem Problem entgegenwirken, dass bei den ersten Hüben eines Ansaugzylinders auch Luft mit angesaugt wird. Erst nach einigen Hüben ist die Luft wieder aus den Leitungen entwichen.

Es hat sich aber herausgestellt, dass diese Entlüftungsventile nicht zuverlässig arbeiten, wenn aggressive Medien wie Säuren angesaugt werden.

Auch bei herkömmlichen gravimetrischen Systemen wie Dosierwaagen ist die Dosiergenauigkeit bestenfalls 10%.

Aufgrund der zu ungenauen Nachdosierung ist eine stabile Prozessführung nicht möglich.

DE 198 15 039 A1 offenbart ein Verfahren zur Reinigung von Siliciumscheiben in einem sauren Reinigungsbad, wobei die Reinigung mehrere Reinigungszyklen umfasst, wobei bei jedem Reinigungszyklus eine bestimmte Menge an Säure verbraucht wird, wobei ein Gesamtverbrauch an Säure im Reinigungsbad abgeschätzt wird und wobei nach Erreichen eines Gesamtverbrauchs an Säure im Reinigungsbad ein Dosiersystem eine gewisse Dosiermenge an unverbrauchter Säure aus einem Vorratsbehälter entnimmt und dem Reinigungsbad zuführt.

Aus der beschriebenen Problematik ergab sich die Aufgabenstellung der Erfindung.

Die Aufgabe wird gelöst durch ein Verfahren zur Reinigung von polykristallinen Siliciumbruchstücken in einem sauren Reinigungsbad, wobei die Reinigung mehrere Reinigungszyklen umfasst, wobei bei jedem Reinigungszyklus eine bestimmte Menge an Säure verbraucht wird, wobei die jeweiligen Verbrauchsmengen eines jeden Reinigungszyklus in einem rechnergesteuerten Dosiersystem als Anlagenparameter hinterlegt sind, wobei mittels eines Integrators des Dosiersystem jene bei jedem Reinigungszyklus verbrauchten Säuremengen zu einem Gesamtverbrauch an Säure im Reinigungsbad aufsummiert werden, wobei nach Erreichen eines Gesamtverbrauchs an Säure im Reinigungsbad von 5-10 1 mittels einer Membrandosierpumpe oder wobei nach Erreichen eines Gesamtverbrauchs an Säure im Reinigungsbad von 10-30 1 mittels eines gravimetrischen Dosiersystems, eine dem Gesamtverbrauch an Säure im Reinigungsbad entsprechende Menge an unverbrauchter Säure einem Vorratsbehälter entnommen und diese dem Reinigungsbad zugeführt wird, wobei das Verhältnis von umgewälzter Säuremenge in Liter zur Masse der im Reinigungsbad befindlichen Polysiliziumbruchstücke in kg größer als 10 beträgt.

Das erfindungsgemäße Verfahren betrifft die Reinigung von polykristallinen Siliciumbruchstücken.

Beim polykristallinen Silicium handelt es sich vorzugsweise um Bruchstücke der Bruchgrößen BG 1 bis BG 6.

Die Reinigung erfolgt in einem Reinigungsbad, das eine saure Reinigungsflüssigkeit enthält bzw. in das eine saure Reinigungsflüssigkeit nachdosiert wird.

Zur Reinigung kommen vorzugsweise wässrige Mischungen von Säuren wie HF oder HNO₃ zum Einsatz.

Vorzugsweise handelt es sich um eine wässrige Mischung aus HF und HNO₃.

Vorzugsweise umfasst das Säurebad eine oder mehrere der Säuren ausgewählt aus der Gruppe bestehend aus HF, HNO₃, H₂O₂ und HCl.

Die Reinigung umfasst mehrere Reinigungszyklen.

Ein Reinigungszyklus oder Takt zeichnet sich dadurch aus, dass eine (oder mehrere) Prozessschale(n), jeweils gefüllt mit vorzugsweise etwa 5 bis 10 kg Polysiliziumbruchstücken, mittels eines geeigneten Handhabungssystems in ein Säurebad eingebracht und nach 1 bis 1000 sec wieder entnommen wird bzw. werden.

Pro Reinigungszyklus wird eine bestimmte Menge an Säure verbraucht.

Diese Menge ist je nach Bruchgröße des Polysiliciums unterschiedlich, was mit den unterschiedlichen spezifischen Oberflächen der Bruchgrößen zusammenhängt.

Vorzugsweise werden beim erfindungsgemäßen Verfahren nacheinander unterschiedliche Bruchgrößen des polykristallinen Silicium gereinigt.

Vorzugsweise werden zunächst polykristalline Siliciumbruchstücke einer ersten Bruchgröße gereinigt, die eine kleinere spezifische Oberfläche aufweisen als die nachfolgend im gleichen Reinigungsbad gereinigten polykristallinen Siliciumbruchstücke einer zweiten Bruchgröße.

Damit wird die Nachdosierung an die sich ändernden spezifischen Oberflächen des Polysiliciums angepasst.

Die nachzudosierende Menge an Säure hängt von der Bruchgröße des Silicium und bei Einsatz von mehr als einer Säure auch vom Säuretyp ab.

Bei einem bevorzugt eingesetzten Gemisch von HF/HNO₃ werden sowohl HF als auch HNO₃ nachdosiert. Für beide Bestandteile des Gemisches ist vorzugsweise ein eigenes Dosiersystem vorgesehen.

Die Dosiermenge für HNO₃ ist höher als die Dosiermenge für HF, wie später anhand eines Beispiels gezeigt wird.

Vorzugsweise sind alle Dosiermengen pro Reinigungszyklus für jede der zu reinigenden Bruchgrößen im computergesteuerten Dosiersystem hinterlegt.

Vorzugsweise werden Erfahrungswerte und/oder experimentell bestimmte Verbrauchsmengen für jede Bruchgröße als Parameter in einem Rezept des computergesteuerten Dosiersystems hinterlegt.

Diese Verbrauchsmengen werden mit einem Integrator des computergesteuerten Dosiersystems während der einzelnen Reinigungszyklen aufsummiert.

Somit steht nach jedem Reinigungszyklus ein aktueller Gesamtverbrauch an Säure im Reinigungsbad zur Verfügung.

Erfindungsgemäß wird jedoch erst dann unverbrauchte (frische) Säure nachdosiert, wenn der aktuelle Gesamtverbrauch an Säure im Reinigungsbad einem optimalen Dosierbereich des Dosiersystems entspricht.

Es ist also nicht bevorzugt, nach jedem Reinigungszyklus sofort nachzudosieren, was eigentlich naheliegen würde. Es hat sich nämlich gezeigt, dass so die gewünschte Prozessstabilität nicht erreicht würde.

Als Dosiersysteme können Membranpumpen, vorzugsweise Druckluftmembranpumpen, oder andere Dosierpumpen, bevorzugt Motordosierpumpen, zum Einsatz kommen.

Ebenso eignen sich gravimetrische Dosiersysteme, bevorzugt Dosierwaagen.

Auch können mehrere dieser Dosiersysteme ausgewählt aus der Gruppe bestehend aus Druckluftmembranpumpe, Motordosierpumpe und gravimetrisches Dosiersystem parallel verwendet werden.

Vorzugsweise ist für jede nachzudosierende Säure ein eigenes Dosiersystem vorgesehen.

Die optimalen Dosiermengen für die eingesetzten Dosiersysteme basieren vorzugsweise jeweils auf Erfahrungswerten, die durch Untersuchungen der Prozessstabilität für verschiedene Bruchgrößen und Dosiermengen gewonnen werden können.

Druckluftmembranpumpen und Motordosierpumpen haben üblicherweise eine Dosierleistung von 1 bis 20 l/min. In einer Minute können also bis zu 20 1 dosiert werden.

Die Erfinder haben im Rahmen von experimentellen Untersuchungen festgestellt, dass bei Dosiermengen von 1 bis 2 1 mit solchen Pumpen nur eine Dosiergenauigkeit von bestenfalls 10% erreicht wird. Dies hängt insbesondere mit der zuvor geschilderten Unzuverlässigkeit der Entlüftungsventile zusammen. Pro Hub der Pumpe werden ca. 200 ml gefördert. Erst nach 10 Hüben (= 2 1 Dosiermenge) ist die angesaugte Luft aus den Leitungen entwichen.

Erst oberhalb von ca. 5 bis 10 Liter Dosiermenge arbeiten die Druckluftmembranpumpen mit der erforderlichen Genauigkeit. Jene ca. 5 bis 10 Liter entsprechen im Fall der Druckluftmembranpumpen der optimalen Dosiermenge.

Beim Einsatz eines gravimetrischen Dosiersystems wird zunächst ein Gefäß mit Säure aus einem Vorratstank befüllt und gewogen.

Vorzugsweise wird das Gefäß nicht vollständig, sondern mit höchstens 75% der maximalen Füllmenge befüllt. Ein Gefäß mit einer maximalen Füllmenge von 20 1 wird beispielsweise mit maximal 15 1 befüllt.

Die optimale Dosiermenge beträgt je nach Größe des Gefäßes etwa 10 bis 30 l. Größere Gefäße, die auch höhere Dosiermengen ermöglichen würden, sind wenige bevorzugt, da dies auf Kosten der Dosiergenauigkeit bei kleinen Dosiermengen geht.

Allerdings muss sich die Waage vor jedem weiteren Dosiervorgang erst beruhigen. Dies hat zur Folge, dass nur alle 3 Minuten ein Dosiervorgang erfolgen kann.

Bei einer Dosiermenge von 15 1 sind also maximal 300 l/h Dosierleistung möglich.

Auch hat sich gezeigt, dass das Verhältnis zwischen der in einem Chemiebad befindlichen Menge an zu reinigendem Polysiliciumbruch zur umgewälzten Säuremenge einen signifikanten Einfluss auf das Ansprechverhalten gegenüber dem Säureverbrauch hat.

Ist das Verhältnis (Umgewälzte Säuremenge in l / Menge an Polybruch in kg im Chemiebad) kleiner als 10, können die Badkonzentrationen nicht stabil gehalten werden.

Der Fehlbedarf an Mindestmenge führt bereits zu einem deutlichen Abfall in der Säurekonzentration größer als 10%.

Dies ist mit stark schwankenden Prozessbedingungen verbunden. Bei einem Verhältnis (Umgewälzte Säuremenge in l / Menge an Polybruch in kg im Chemiebad) kleiner als 10, führt die abgehende Mindestmenge zu einer Prozessschwankung größer als 10%.

Ist dagegen das Verhältnis (Umgewälzte Säuremenge in l / Menge an Polybruch in kg im Chemiebad) größer als 10, können die Badkonzentrationen stabil gehalten werden.

Der Fehlbedarf an der Mindestmenge führt auf Grund der großen Pufferwirkung zu einem Abfall in der Säurekonzentration von kleiner als 10%.

Dies führt zu stabileren Säurekonzentrationen.

Nur bei einem Verhältnis (Umgewälzte Säuremenge in l / Menge an Polybruch in kg im Chemiebad) von größer als 10 führt die abgehende Mindestmenge zu einer Prozessschwankung von kleiner als 10%.

Daher betrifft die Erfindung auch ein Verfahren zur Reinigung von polykristallinen Siliziumbruchstücken in einem sauren Reinigungsbad, das einen Säurekreislauf umfasst, in dem Säure umgewälzt wird, dadurch gekennzeichnet, dass das Verhältnis von umgewälzter Säuremenge in Liter zur Masse der im Reinigungsbad befindlichen Polysiliziumbruchstücke in kg größer als 10 beträgt.

Vorzugsweise beträgt das Verhältnis von umgewälzter Säuremenge in Liter zur Masse der im Reinigungsbad befindlichen Polysiliziumbruchstücke in kg 15 bis 200, besonders bevorzugt 50 bis 170 und ganz besonders bevorzugt 100 bis 150.

Für die Reinigung von 10 kg Polysiliziumbruch sind mehr als 100 1 Säure umzuwälzen.

### Beispiele

Eine Dosiermenge pro Reinigungszyklus bzw. Takt ist für jede Bruchgröße des Polysiliciums in einem Rezept hinterlegt. Auch die Mindestdosiermenge, die mit einer Genauigkeit von 10% oder besser dosiert werden kann, ist als Anlagenparameter hinterlegt.

Der Integrator des Dosiersystems addiert die fehlende Säuremenge im Bad, bis die erlaubte Mindestdosiermenge erreicht ist.

Das Dosiersystem springt an, wenn der Integrator anzeigt, dass die erlaubte Mindestmenge im Säurekreis fehlt.

Anschließend fördert das Dosiersystem die erlaubte Mindestmenge aus einem Vorratsbehälter enthaltend die nachzudosierende Reinigungsflüssigkeit oder Säure.

Die erlaubte Mindestmenge wird dem Säuremischkreis des Reinigungsbades zugeführt.

Die nachfolgenden Tabellen 1 und 2 beziehen sich auf ein Reinigungsbad, in dem sich vier Prozessschalen befinden. Die Prozessschalen dienen dazu, das zu reinigende Polysilicium aufzunehmen.

Tabelle 1 zeigt Dosiermengen an HF und HNO₃ für die verschiedenen Bruchgrößen in l/Takt (bzw. l/Reinigungszyklus).

**Tabelle 1**

| Bruchgröße | HF 60 Gew.-% in l/Takt | HNO₃ 85 Gew.-% in l/Takt |
|---|---|---|
| 6 | 0,02 | 0,1 |
| 5 | 0,2 | 1 |
| 4 | 0,4 | 1,4 |
| 3 | 0,6 | 3,2 |
| 2 | 1,2 | 7,2 |

**Tabelle 2** zeigt Dosiermengen an HF und HNO₃ für die verschiedenen Bruchgrößen in l/h

**Tabelle 2**

| Bruchgröße | HF in l/h | HNO₃ in l/h |
|---|---|---|
| 6 | 1 | 6 |
| 5 | 12 | 60 |
| 4 | 22 | 86 |
| 3 | 40 | 204 |
| 2 | 80 | 720 |

Es ist zu erkennen, dass sich die Dosiermengen für die einzelnen Bruchgrößen stark unterscheiden.

Im Säurekreislauf befinden sich 3000 Liter HF/HNO₃ im Umlauf.

Pro Prozessschalengruppe werden in Abhängigkeit der Produkte stark unterschiedliche Mengen benötigt:
Erst wenn eine Mindestmenge von 10 1 HF bzw. 10 1 HNO₃ erreicht ist, dosiert die Druckluftmembranpumpe nach.

Pro Takt werden vier Prozessschalen mit jeweils 5 kg Polybruch gereinigt.

Das Verhältnis (Umgewälzte Säuremenge in l / Menge an Polybruch in kg im Chemiebad) beträgt 150.

Dadurch hat das Säurebad eine große Pufferwirkung.

Die Dosierung erfolgt mit einer Druckluftmembranpumpe, wobei die fehlenden Säuremengen pro Takt auf eine Mindestmenge sowohl für HF wie auch für HNO₃ von 10 1 addiert wurden und erst dann die Nachdosierung in den Säuremischkreis erfolgt.

### Ätzen von verschiedenen Bruchgrößen

Es wurden verschiedene Bruchgrößen erfindungsgemäß gereinigt. Zunächst wurde Polysilicium der Bruchgröße 6 gereinigt, dann Bruchgröße 5 usw.

**Tabelle 3** zeigt, zu welchen Uhrzeiten die verschiedenen Bruchgrößen gereinigt wurden.

**Tabelle 3**

| Uhrzeit | Bruchgröße |
|---|---|
| 6 bis 7 Uhr | 6 |
| 7 bis 8 Uhr | 5 |
| 8 bis 9 30 Uhr | 4 |
| 9 30 bis 11 Uhr | 3 |
| 11 bis 12 Uhr | 2 |

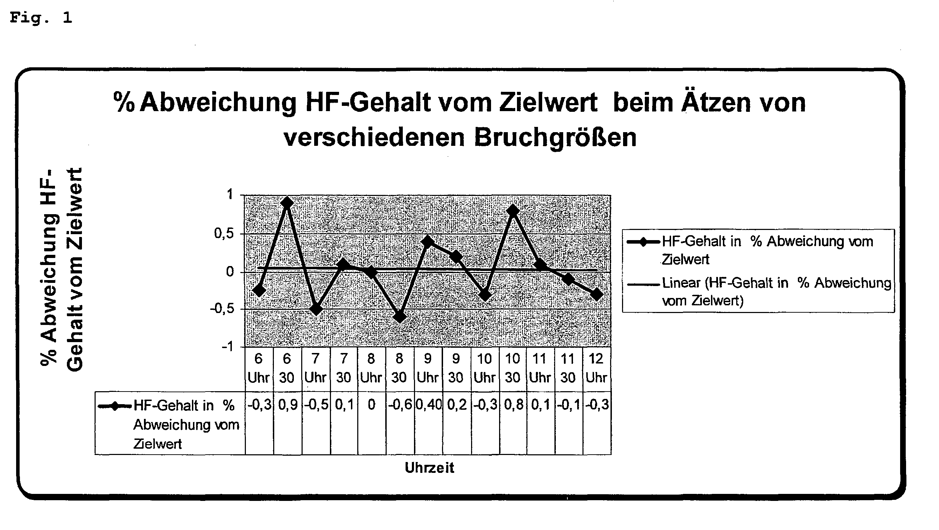

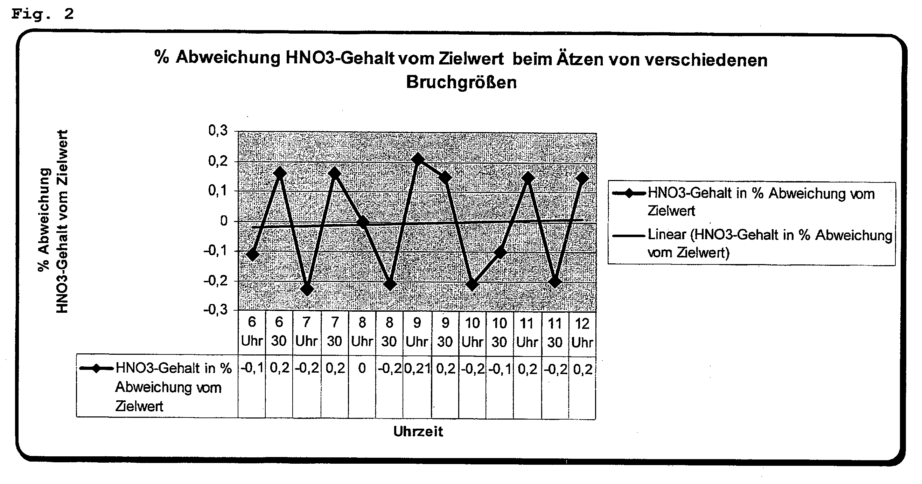

Die Erfindung wird nachfolgend auch anhand von **Fig. 1** und **Fig. 2** erläutert.

**Fig. 1** zeigt den Gehalt an HF im Reinigungsbad in Gew.-% für die zu unterschiedlichen Zeiten gereinigten Bruchgrößen gemäß **Tabelle 3.**

**Fig. 2** zeigt den Gehalt an HNO₃ im Reinigungsbad in Ges.-% für die verschiedenen Bruchgrößen gemäß Reinigungsplan nach **Tabelle 3.**

Den **Fig. 1** **und** **2** kann entnommen werden, dass der HF und HNO3 - Gehalt in der Ätzlösung unabhängig von der Bruchgröße die gereinigt wird, nur sehr gering schwankt.

Dies zeigt die besonderen Vorteile des erfindungsgemäßen Verfahrens.

Die Erfindung ermöglicht es, durch eine rechnergesteuerte Verzögerung der Nachdosierung auf Basis von ermittelten optimalen Dosiermengen für herkömmliche, relativ kostengünstige Dosiersysteme, eine im Stand der Technik bislang nicht erreichte Prozessstabilität durch exaktere Dosierung sicherzustellen.

Der Gesamtverbrauch an Säure ist niedriger als bei den im Stand der Technik angewendeten Verfahren mittels Konzentrationsmessungen oder Titrationsverfahren. Damit ist das neue Verfahren auch wirtschaftlicher als die bekannten Methoden.

## Patentansprüche

1. Verfahren zur Reinigung von polykristallinen Siliziumbruchstücken in einem sauren Reinigungsbad, das einen Säurekreislauf umfasst, in dem Säure umgewälzt wird, wobei die Reinigung mehrere Reinigungszyklen umfasst, wobei bei jedem Reinigungszyklus jeweils eine bestimmte Menge an Säure verbraucht wird, wobei die jeweiligen Verbrauchsmengen eines jeden Reinigungszyklus in einem rechnergesteuerten Dosiersystem als Anlagenparameter hinterlegt sind, wobei mittels eines Integrators des Dosiersystem jene bei jedem Reinigungszyklus verbrauchten Säuremengen zu einem Gesamtverbrauch an Säure im Reinigungsbad aufsummiert werden, wobei nach Erreichen eines Gesamtverbrauchs an Säure im Reinigungsbad von 5-10 1 mittels einer Membrandosierpumpe oder wobei nach Erreichen eines Gesamtverbrauchs an Säure im Reinigungsbad von 10-30 1 mittels eines gravimetrischen Dosiersystems eine dem Gesamtverbrauch an Säure im Reinigungsbad entsprechende Menge an unverbrauchter Säure einem Vorratsbehälter entnommen und diese dem Reinigungsbad zugeführt wird, wobei das Verhältnis von umgewälzter Säuremenge in Liter zur Masse der im Reinigungsbad befindlichen Polysiliziumbruchstücke in kg größer als 10 beträgt.

2. Verfahren nach Anspruch 1, wobei das Verhältnis von umgewälzter Säuremenge in Liter zur Masse der im Reinigungsbad befindlichen Polysiliziumbruchstücke in kg 15 bis 200 beträgt.

3. Verfahren nach Anspruch 2, wobei das Verhältnis von umgewälzter Säuremenge in Liter zur Masse der im Reinigungsbad befindlichen Polysiliziumbruchstücke in kg 50 bis 170 beträgt.

4. Verfahren nach Anspruch 3, wobei das Verhältnis von umgewälzter Säuremenge in Liter zur Masse der im Reinigungsbad befindlichen Polysiliziumbruchstücke in kg 100 bis 150 beträgt.

5. Verfahren nach Anspruch 1, wobei das Dosiersystem eine Dosierpumpe oder eine Dosierwaage umfasst.

6. Verfahren nach Anspruch 1 oder nach Anspruch 5, wobei das Reinigungsbad eine oder mehrere Säuren, ausgewählt aus der Gruppe bestehend aus HF, HCl, H₂O₂ und HNO₃ umfasst.

7. Verfahren nach Anspruch 5 oder nach Anspruch 6, wobei in den mehreren Reinigungszyklen unterschiedliche Größenklassen der Siliciumbruchstücke gereinigt werden.

8. Verfahren nach einem der Ansprüche 5 bis 7, wobei das Reinigungsbad wenigstens zwei Säuren umfasst und für jede Säure ein separates rechnergesteuertes Dosiersystem vorgesehen ist, dass das Reinigungsbad mit unverbrauchter Säure versorgt.

## Claims

1. Process for cleaning polycrystalline silicon chunks in an acidic cleaning bath comprising an acid circuit in which acid is circulated, wherein the cleaning comprises several cleaning cycles, wherein a particular amount of acid is consumed in each cleaning cycle, wherein the respective consumption volumes of each cleaning cycle are recorded in a computer-controlled dosage system as plant parameters, wherein an integrator of the dosage system is used to add up those amounts of acid consumed in each cleaning cycle to give a total consumption of acid in the cleaning bath, wherein, on attainment of a total consumption of acid in the cleaning bath of 5-10 1, by means of a membrane metering pump, or wherein, on attainment of a total consumption of acid in the cleaning bath of 10-30 1, by means of a gravimetric metering system, an amount of unconsumed acid corresponding to the total consumption of acid in the cleaning bath is withdrawn from a reservoir vessel and fed to the cleaning bath, wherein the ratio of amount of acid circulated in liters to the mass of the polysilicon chunks present in the cleaning bath in kg is greater than 10.

2. Process according to Claim 1, wherein the ratio of amount of acid circulated in liters to the mass of the polysilicon chunks present in the cleaning bath in kg is 15 to 200.

3. Process according to Claim 2, wherein the ratio of amount of acid circulated in liters to the mass of the polysilicon chunks present in the cleaning bath in kg is 50 to 170.

4. Process according to Claim 3, wherein the ratio of amount of acid circulated in liters to the mass of the polysilicon chunks present in the cleaning bath in kg is 100 to 150.

5. Process according to Claim 1, wherein the dosage system comprises a dosage pump or a dosage balance.

6. Process according to Claim 1 or according to Claim 5, wherein the cleaning bath comprises one or more acids selected from the group consisting of HF, HCl , H₂O₂ and HNO₃.

7. Process according to Claim 5 or according to Claim 6, wherein different size classes of the silicon chunks are cleaned in the several cleaning cycles.

8. Process according to any of Claims 5 to 7, wherein the cleaning bath comprises at least two acids and a separate computer-controlled dosage system is provided for each acid, and this supplies the cleaning bath with unconsumed acid.

## Revendications

1. Procédé de purification de fragments de silicium polycristallin dans un bain de purification acide qui comprend un circuit d'acide, dans lequel l'acide est mis en circulation, la purification comprenant plusieurs cycles de purification, une quantité déterminée d'acide étant consommée lors de chaque cycle de purification, les quantités consommées respectives de chaque cycle de purification étant saisies en tant que paramètre de l'unité dans un système de dosage commandé par ordinateur, les quantités d'acide consommées lors de chaque cycle de purification étant additionnées en une consommation totale d'acide dans le bain de purification par un intégrateur du système de dosage, une quantité d'acide non consommé correspondant à la consommation totale d'acide dans le bain de purification étant soutirée d'un contenant de stockage lorsqu'une consommation totale d'acide dans le bain de purification de 5 à 10 1 est atteinte par une pompe de dosage à membrane ou lorsqu'une consommation totale d'acide dans le bain de purification de 10 à 30 l est atteinte par un système de dosage gravimétrique, et celle-ci est introduite dans le bain de purification, le rapport entre la quantité d'acide mise en circulation en litres et la masse des fragments de polysilicium se trouvant dans le bain de purification en kg étant supérieur à 10.

2. Procédé selon la revendication 1, dans lequel le rapport entre la quantité d'acide mise en circulation en litres et la masse des fragments de polysilicium se trouvant dans le bain de purification en kg est de 15 à 200.

3. Procédé selon la revendication 2, dans lequel le rapport entre la quantité d'acide mise en circulation en litres et la masse des fragments de polysilicium se trouvant dans le bain de purification en kg est de 50 à 170.

4. Procédé selon la revendication 3, dans lequel le rapport entre la quantité d'acide mise en circulation en litres et la masse des fragments de polysilicium se trouvant dans le bain de purification en kg est de 100 à 150.

5. Procédé selon la revendication 1, dans lequel le système de dosage comprend une pompe de dosage ou une balance de dosage.

6. Procédé selon la revendication 1 ou selon la revendication 5, dans lequel le bain de purification comprend un ou plusieurs acides, choisis dans le groupe constitué par HF, HCl, H₂O₂ et HNO₃.

7. Procédé selon la revendication 5 ou selon la revendication 6, dans lequel différentes classes de taille des fragments de silicium sont purifiées lors des cycles de purification.

8. Procédé selon l'une quelconque des revendications 5 à 7, dans lequel le bain de purification comprend au moins deux acides et un système de dosage commandé par ordinateur séparé est prévu pour chaque acide, qui alimente le bain de purification avec un acide non consommé.
